# EUROPEAN PATENT APPLICATION

(11) **EP 3 249 421 A2**
(43) Date of publication of application: **29.11.2017**
(21) Application number: 17171674.9
(22) Date of filing: 18.05.2017
(51) Int. Cl.: G01S 7/03, G01S 13/93, G01S 7/02

(54) **RADAR APPARATUS AND STARTUP TIMING DETERMINATION METHOD**

(30) Priority: 27.05.2016 JP 2016106278
(71) Applicant: Panasonic Intellectual Property Management Co., Ltd., Osaka-shi, Osaka 540-6207 (JP)
(72) Inventor: OKAZAKI, Yukio, Osaka-shi, Osaka 540-6207 (JP); SATOU, Kazutoshi, Osaka-shi, Osaka 540-6207 (JP); SAITO, Noriaki, Osaka-shi, Osaka 540-6207 (JP)
(74) Representative: Grünecker Patent- und Rechtsanwälte PartG mbB

(57) **Abstract**

A radar apparatus includes a transmitter including a plurality of circuits that intermittently transmit one or more radar signals, the plurality of circuits being suspended power supplying during a period in which the one or more radar signals are not transmitted, variation detection circuitry that detects process variations of the plurality of circuits, and determination circuitry that determines a startup timing of each of the plurality of circuits in response to the process variations and outputs startup commands in response to the determined startup timings to the plurality of circuits.

## Description

### BACKGROUND

### 1. Technical Field

The present disclosure relates to a radar apparatus, and a startup timing determination method.

### 2. Description of the Related Art

Radar apparatuses have been studied which use short-wavelength radar signals, including microwave signal and millimeter wave signals, which provide higher resolutions. For example, such radar apparatuses include a pulse radar that repeatedly transmits a pulse wave.

There is a possibility of interference between pulses on the same frequency if a pulse radar is mounted on a vehicle to be used as a sensor for collision control or if multiple pulse radars are employed. In view of this, encoded pulse radars are used. The encoded pulse radars encode radar wave signals (in pulse compression processing) to identify the radar wave signal of each of multiple pulse radars. The radar apparatus uses phase modulation in a typically encoded pulse, and orthogonal modulation and orthogonal demodulation are respectively used in a transmitter and a receiver.

Japanese Unexamined Patent Application Publication No. 2006-112915 discloses a technique concerning a pulse radar. The pulse radar of related art shortens an on-period of the intermittent transmission operation at a higher temperature and lengthens the on-period of the intermittent transmission operation at a lower temperature in response to the output from a temperature sensor on a semiconductor chip. The pulse radar thus reduces temperature variations of the semiconductor chip and reduces characteristic variations of the pulse radar in response to a temperature change by varying power consumption in response to the temperature of the semiconductor chip.

See, for example, Tsukizawa et. al. "A PVT-Variation Tolerant Fully Integrated 60 GHz Transceiver for IEEE802.11ad," 2014 Symposium on VLSI Circuits.

In the related art techniques, the power consumption of the pulse radar depends on not only the temperature of semiconductors but also on variations of semiconductors (namely, process variations).

### SUMMARY

One non-limiting and exemplary embodiment facilitates providing a radar apparatus that performs a radar process with a pulse radar in a power-consumption reduced state, and a startup timing determination method of the radar apparatus.

In one general aspect, the techniques disclosed here feature a radar apparatus including a transmitter including a plurality of circuits that intermittently transmit one or more radar signals, the plurality of circuits being suspended power supplying during a period in which the one or more radar signals are not transmitted, variation detection circuitry that detects process variations of the plurality of circuits, and determination circuitry that determines a startup timing of each of the plurality of circuits in response to the process variations and outputs startup commands in response to the determined startup timings to the plurality of circuits.

General or specific embodiments may be implemented as a system, an apparatus, a method, or any selective combination thereof.

According to the disclosure, the pulse radar may perform the radar process in a power-consumption reduced state.

It should be noted that general or specific embodiments may be implemented as a system, a method, an integrated circuit, a computer program, a storage medium, or any selective combination thereof.

Additional benefits and advantages of the disclosed embodiments will become apparent from the specification and drawings. The benefits and/or advantages may be individually obtained by the various embodiments and features of the specification and drawings, which need not all be provided in order to obtain one or more of such benefits and/or advantages.

### BRIEF DESCRIPTION OF THE DRAWINGS

Fig. 1 illustrates an example of a radar apparatus of a first embodiment;
Fig. 2A illustrates an example of a startup timing of each element of the first embodiment;
Fig. 2B illustrates an example of a startup timing of each element of the first embodiment;
Fig. 3A illustrates an example of a startup timing of each element of the first embodiment;
Fig. 3B illustrates an example of a startup timing of each element of the first embodiment; and
Fig. 4 illustrates an example of a radar apparatus of a second embodiment.

### DETAILED DESCRIPTION

Embodiments of the disclosure are described below with reference to the drawings.

### First Embodiment

### Configuration of apparatus

A configuration of a radar apparatus of a first embodiment of the disclosure is described below.

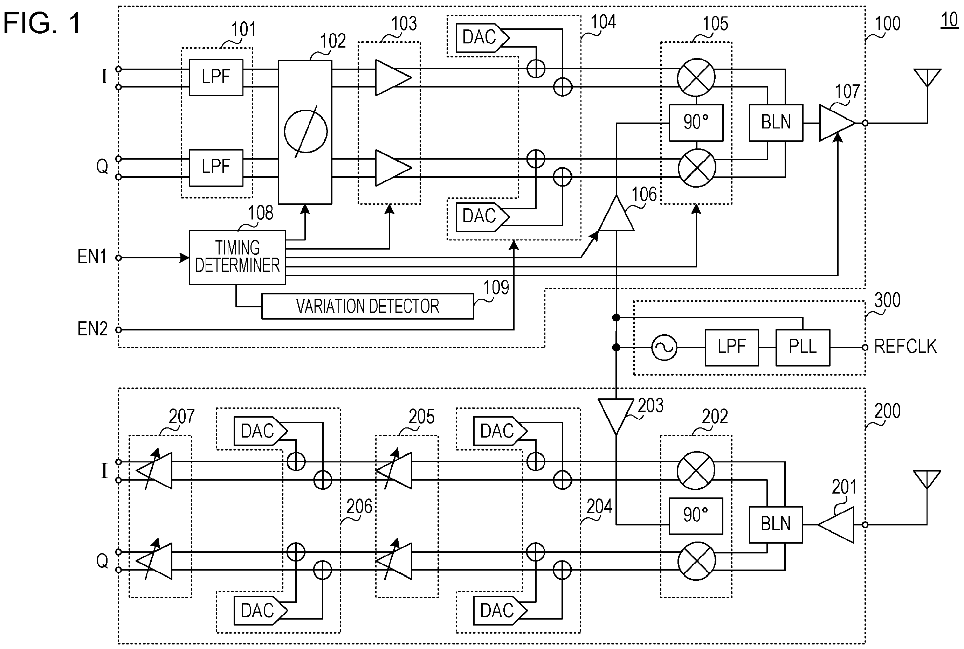

Fig. 1 illustrates an example of a radar apparatus 10 of a first embodiment. Referring to Fig. 1, the radar apparatus 10 includes a radar transmitter 100, a radar receiver 200, and a local signal generator 300. Fig. 1 illustrates the configuration of a radio frequency (RF) front end of the radar apparatus 10.

The radar transmitter 100 generates a radar signal (such as a millimeter-wave high-frequency signal) using an encoded pulse (a baseband signal (IQ signal)) input from a signal processor (not illustrated) modulating a local signal input from the local signal generator 300. In the discussion that follows, the phrase "high-frequency signal" refers to a radio signal. Using an antenna, the radar transmitter 100 intermittently transmits a radar signal (in intermittent transmission). During an interval between transmission timings of the radar signal (a period of time throughout which the radar signal is not transmitted), power supplying to multiple circuits in the radar transmitter 100 is suspended, causing the multiple circuits to stop the operation thereof.

Using an antenna, the radar receiver 200 receives a signal that is a radar signal reflected from a target (not illustrated). The radar receiver 200 performs a reception process on the reflected signal in synchronization with the radar transmitter 100 using the local signal input from the local signal generator 300. The radar receiver 200 includes a low-noise amplifier (LNA) 201, a mixer 202, a local buffer amplifier 203, direct-current (DC) offset adjusters 204 and 206 of basebands, and baseband variable gain amplifiers 205 and 207.

The local signal generator (local oscillator) 300 is respectively connected to the radar transmitter 100 and the radar receiver 200. The local signal generator 300 applies a local signal to each of the radar transmitter 100 and the radar receiver 200. The local signal generator 300 may include a phase lock circuit (PLL) circuit, a low-pass filter (LPF), and an oscillator.

### Configuration of radar transmitter

The radar transmitter 100 of Fig. 1 includes an LPF 101, a baseband phase shifter 102, a baseband buffer amplifier 103, a DC offset adjuster 104, an orthogonal modulation mixer 105, a local buffer amplifier 106, a power amplifier 107, a timing determiner 108, and a variation detector 109.

The LPF 101 removes alias harmonics from an encoded pulse (IQ signal) that is the baseband signal.

The baseband phase shifter 102 performs a phased array function by imparting an appropriate phase rotation to an input encoded signal to gain a desired beam directivity.

The baseband buffer amplifier 103 amplifies an output signal from the baseband phase shifter 102 (namely, a baseband signal).

The DC offset adjuster 104 adds a DC offset to the output signal from the baseband buffer amplifier 103, thereby performing a DC offset correction (to adjust a modulation error of the radar signal). The DC offset adjuster 104 may include a digital-to-analog converter (DAC) and an adder that adds a DC bias to the baseband signal.

The orthogonal modulation mixer 105 performs orthogonal modulation on the output signal from the DC offset adjuster 104, thereby up-converting the output signal to a high-frequency band (in frequency conversion).

The local buffer amplifier 106 amplifies a local signal input from the local signal generator 300. Alternatively, the radar transmitter 100 may input to the local buffer amplifier 106 the local signal whose frequency has been increased to a specific frequency (in a millimeter wave band) by a multiplied-by-N circuit (not illustrated) (N is an integer equal to or above 1).

The power amplifier 107 amplifies the output signal (namely, a radio signal) from the orthogonal modulation mixer 105 applied through a balun (BLN). The amplified signal is transmitted via the antenna.

The timing determiner 108 determines startup timings of elements in the radar transmitter 100 including the baseband phase shifter 102, the baseband buffer amplifier 103, the orthogonal modulation mixer 105, the local buffer amplifier 106, and the power amplifier 107. For example, the timing determiner 108 determines the startup timing of each element in response to a control signal input from a signal processor (not illustrated) to control the startup of the radar transmitter 100 (the control signal is an enable signal and hereinafter referred to as an EN1 signal) and information input from the variation detector 109. The timing determiner 108 outputs respectively startup commands responsive to the determined startup timings to the elements. In this way, the elements start up at the determined startup timings thereof. A determination method of the startup timing of the timing determiner 108 is described below in detail.

The startup timing of the DC offset adjuster 104 is determined by a control signal (the control signal is an enable signal and hereinafter referred to as an EN2 signal) input from the signal processor (not illustrated) to control the startup of the DC offset adjuster 104.

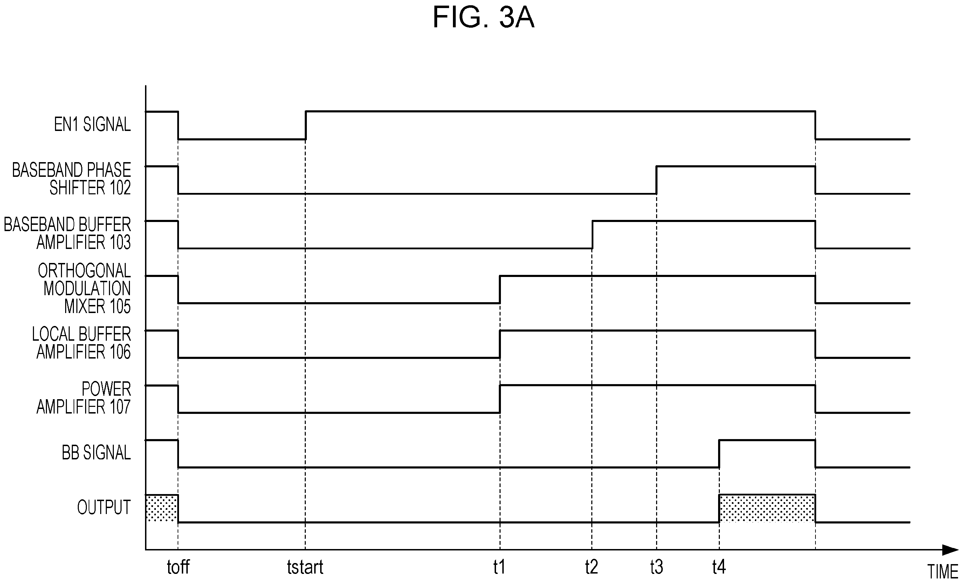

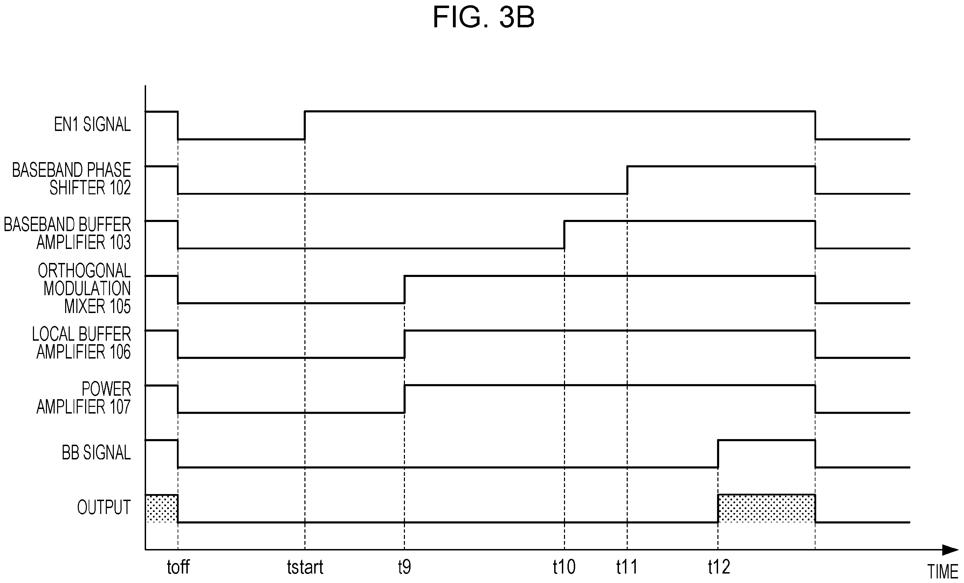

The variation detector 109 detects process variations of a semiconductor chip on which elements (circuits) of the radar transmitter 100 are mounted. For example, the variation detector 109 detects variations from the standard values of the threshold voltage (hereinafter referred to as Vth) of a metal-oxide semiconductor (MOS) transistor, the resistance value of each resistor, and the capacitance value of each capacitor in an integrated circuit (IC) forming the radar transmitter 100. A specific measurement method to measure the variations, for example, to measure the Vth voltage of the MOS transistor is described. As illustrated in Fig. 3 of the paper entitled "A PVT-Variation Tolerant Fully Integrated 60 GHz Transceiver for IEEE802.11 ad", a constant current IBGR is caused to flow through a target element and a voltage generated across the target element may be used for comparison. To measure variations of each resistor, an external standard resistor is prepared as an individual resistor, a standard current determined by the standard resistor is caused to flow through a resistor in the IC, and a comparator compares a voltage across the resistor with a voltage across the standard resistor. The process variations are thus detected. To measure variations of each capacitor, a circuit to measure an RC time constant in the IC may be used (the circuit to count the frequency of an RC oscillator) to measure the process variations. The variation detector 109 thus detects the process variations in accordance with these detection methods.

### Process of radar transmitter 100

A determination method of the startup timing of each element in the radar transmitter 100 is described in detail below.

The radar transmitter 100 of Fig. 1 includes a baseband circuit working with a baseband signal. The baseband circuit includes the LPF 101, the baseband phase shifter 102, the baseband buffer amplifier 103, and the DC offset adjuster 104. The radar transmitter 100 also includes a high-frequency circuit (hereinafter also referred to as a millimeter wave high-frequency circuit) working with a high-frequency signal (a high-frequency signal in a millimeter wave band, for example). The high-frequency circuit includes the orthogonal modulation mixer 105, the local buffer amplifier 106, and the power amplifier 107.

The high-frequency circuit working in the millimeter wave band involves higher charging and discharging currents to drive elements, leading to a higher circuit current. To satisfy wiring current tolerance, the size of an element forming the high-frequency circuit is larger than the size of an element forming a high-frequency circuit using a frequency lower than the millimeter wave band. For example, a source-grounded amplifier having an operational frequency of 80 GHz employs a transistor having a size of W/L = 40 µm / 40 nm. In the high-frequency circuit, a bias current of several mA to several tens of mA is generated from a constant current source determining a current (several µA through several tens of µA), and a period of time to charge a gate or a decoupling capacitor becomes longer. For this reason, the high-frequency circuit takes longer time to start up than the baseband circuit.

The timing determiner 108 sets the startup timing of the high-frequency circuit consuming a higher current used to drive an element to be earlier than the baseband circuit consuming a lower current used to drive an element.

The timing determiner 108 adjusts the startup timings of elements in the radar transmitter 100 in response to the process variations of a semiconductor chip detected by the variation detector 109.

The variation detector 109 detects a variation in the threshold voltage (hereinafter referred to as "Vth") of a semiconductor (such as a MOS transistor).

In the following discussion, a "fast" state represents a state having a high-speed operational condition when the threshold voltage Vth of the MOS transistor is lower because of the process variations, and a "slow" state represents a state having a low-speed operation condition when the threshold voltage Vth of the MOS transistor is higher because of the process variations. A "typ" (typical) state represents a state having standard operational condition in which the threshold voltage Vth of the MOS transistor is between the fast and the slow state. More specifically, the gate voltage to start up the semiconductor is lower and a period of time from the beginning of the startup operation to the actual startup of the MOS transistor is shorter when the process variations cause the operational condition of the transistor to be in the "fast" state than when the process variations cause the operational condition of the transistor to be in the "slow" state.

The timing determiner 108 sets the startup timing to be later when the process variations cause the operational condition of the circuit of the radar transmitter 100 to be in the "fast" state than when the process variations cause the operational condition of the circuit of the radar transmitter 100 to be in the "typ". The timing determiner 108 sets the startup timing to be earlier when the process variations cause the operational condition of the circuit of the radar transmitter 100 to be in the "slow" state than when the process variations cause the operational condition of the circuit of the radar transmitter 100 to be in the "typ".

The baseband signal is applied from the DAC (not illustrated) of the baseband to the input terminal of the LPF 101 of Fig. 1. An input portion of the circuit of the radar transmitter 100, namely, the LPF 101 in the radar transmitter 100, continues to be on for an intermittent transmission period.

The radar transmitter 100 performs orthogonal modulation. The DC offset adjuster 104 corrects an orthogonal errors (DC offset). The DC offset value of the DC offset adjuster 104 is set to be at a control accuracy level by the unit of mV in a typical mixer. The circuit of the DC offset adjuster 104 has a larger element area on a semiconductor to ensure a relative accuracy of the element, and it takes time to be stabilized when powered on. If the DC offset adjuster 104 is turned on and off in synchronization with the intermittent transmission operation (on and off operation) of the radar transmitter 100, the startup timing of the DC offset adjuster 104 fails to be in time for a radar transmission startup timing, and it is thus difficult to transmit a front portion of an encoded pulse.

The radar transmitter 100 controls the startup of the DC offset adjuster 104 using a control signal (EN 2 signal) different from the EN1 signal. The radar transmitter 100 transmits the encoded pulse repeatedly to turn on the EN2 signal for a period of time throughout which the intermittent transmission operation is performed. In other words, the radar transmitter 100 does not turn off the DC offset adjuster 104 while the radar transmitter 100 performs the intermittent transmission operation. In this way, the DC offset adjuster 104 maintains an on-state during the intermittent transmission time. When orthogonal modulation is performed in the intermittent transmission time, the radar transmitter 100 thus transmits all the encoded pulses by starting up in advance an element, such as the DC offset adjuster 104, which takes time from the startup to the on-operation.

In order to receive the encoded pulse reflected from any direction, the radar receiver 200 stays turned on during the intermittent transmission time of the radar transmitter 100.

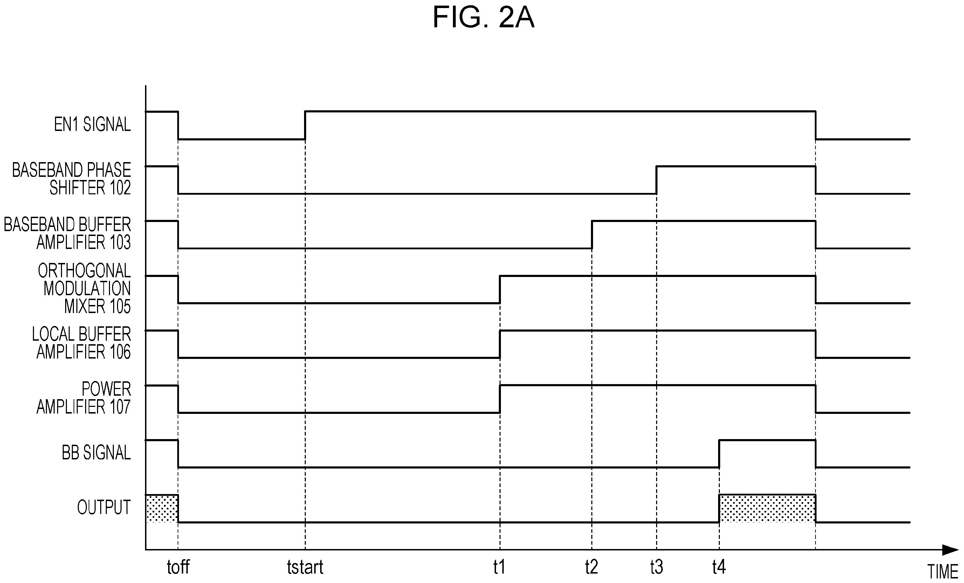

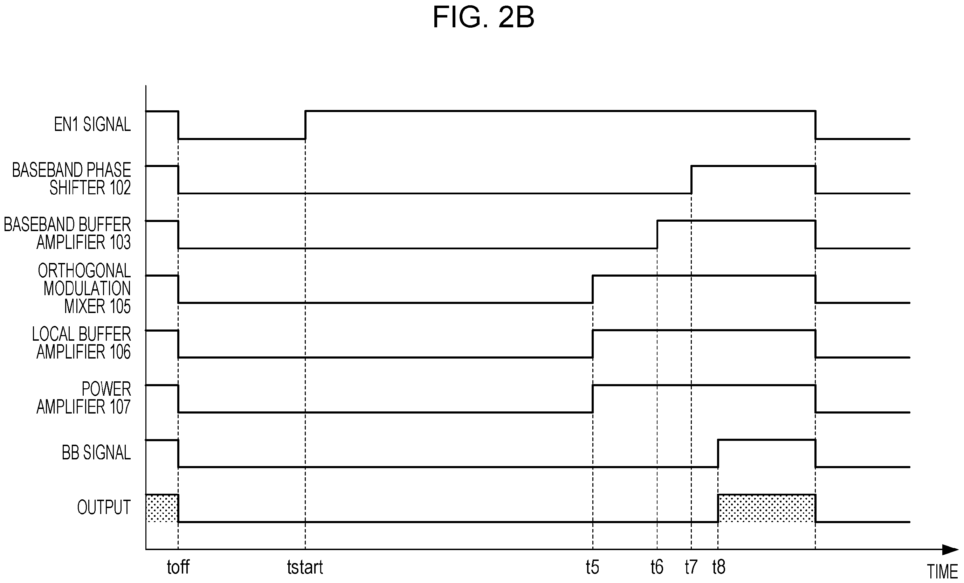

Fig. 2A, Fig. 2B, Fig. 3A, and Fig. 3B illustrate examples of the startup timings of the elements of the radar transmitter 100 and on and off periods of the intermittent transmission operation.

Fig. 2A and Fig. 3A illustrate the startup timings in the "typ" state (with the threshold voltage Vth in the middle). Fig. 2B illustrates the startup timing in the "fast" state (with the threshold voltage Vth being lower), and Fig. 3B illustrates the startup timing in the "slow" state (with the threshold voltage Vth being higher).

Referring to Fig. 2A, Fig. 2B, Fig. 3A, and Fig. 3B, the intermittent transmission operation of the radar transmitter 100 is in the on state at first. All the elements in the radar transmitter 100 transition to the off state at a timing toff at which a value 0 (a value indicating the suspended startup) of the EN1 signal (control signal) is input.

### Typ state

Referring to Fig. 2A and Fig. 3A, when a value 1 (a value indicating the beginning of the startup) as the EN1 is input as a signal (control signal) at a timing tstart, the timing determiner 108 determine the startup timings of the elements to be timings t1, t2, and t3 from a specific time elapse from tstart. The timing determiner 108 may also determine the timings t1, t2, and t3 from tstart using a program counter including a flipflop working on a clock signal separately supplied.

More specifically, the timing determiner 108 outputs a startup command to the high-frequency circuit such that the high-frequency circuit starts up at the earliest possible timing t1. The high-frequency circuit includes the orthogonal modulation mixer 105, the local buffer amplifier 106, and the power amplifier 107. The timing determiner 108 also outputs a startup command to the baseband buffer amplifier 103 serving as a baseband circuit such that the baseband buffer amplifier 103 starts up at the second earliest possible timing t2. The timing determiner 108 also outputs a startup command to the baseband phase shifter 102 serving as a baseband circuit such that the baseband phase shifter 102 starts up at the latest timing t3.

The sequential order of commands output by the timing determiner 108 has a relationship of t1 < t2 ≤ t3. It is sufficient if the baseband phase shifter 102 (having the startup timing t3) and the baseband buffer amplifier 103 (having the startup timing t2) become stabilized before the orthogonal modulation mixer 105 starts up, and the relationship of t2 ≤ t3 thus holds.

At a timing t4 after all the elements are started up, baseband signals (BB signals or IQ signals) are supplied from a baseband IC (not illustrated). The radar transmitter 100 transmits the encoded pulse.

The timing determiner 108 determines the startup timing that is in time for an output timing t4 of the encoded pulse in view of a period of time used to start up each of the elements of the radar transmitter 100. If all the elements in the radar transmitter 100 are concurrently started up, an element (the baseband circuit) waits on standby until a timing at which an element having slow startup characteristics (such as the high-frequency circuit) starts up. This leads to an increase in the power consumption. In other words, the duty factor of the intermittent operation is determined by the startup time of the element having the slowest startup characteristics. It is difficult to reduce the power consumption of the element having the fastest startup characteristics. In accordance with the embodiment, the startup timings set responsive to the startup characteristics of the elements are set. Each element is free from power consumption that may be involved in waiting on standby until the other elements start up, and a lower power consumption design is thus introduced.

The disclosure is not limited to all the high-frequency circuit that start up at the timing t1. In accordance with the embodiment, the high-frequency circuit has a feature that the high-frequency circuit starts up earlier than the baseband circuit. The startup timing may be set to be variable in response to the startup time of each high-frequency circuit.

### Fast state

Referring to Fig. 2B, the sequential order of a startup timing t5 of the orthogonal modulation mixer 105, the local buffer amplifier 106, and the power amplifier 107, a startup timing t6 of the baseband buffer amplifier 103, and a startup timing t7 of the baseband phase shifter 102 is identical to the sequential order in the typ state (Fig. 2A), and has a relationship of t5 < t6 ≤ t7.

Referring to Fig. 2B, the timing t8 at which the radar transmitter 100 outputs the encoded pulse is identical the timing t4 in the "typ" state.

Referring to Fig. 2B, however, the timing determiner 108 sets the startup timings t5, t6, and t7 to be respectively later than the startup timings t1, t2, and t3 of the elements in the typ state. Namely, the relationship of t1 < t5, t2 < t6, and t3 < t7 holds true.

Alternatively, the timing determiner 108 may determine the timings t5, t6, and t7 from tstart using a program counter including a flipflop that works on a separately supplied clock signal. The timing determiner 108 may vary the startup timings t5, t6, and t7 satisfying the above relationship in response to the process variations. For example, the timing determiner 108 may record, in advance, count values responsive to the process variations in a lookup table (LUT). The timing determiner 108 may calculate the count values in response to the output of the variation detector 109.

Since periods of time to start up the elements in the radar transmitter 100 are shorter in the fast state, the timing determiner 108 sets the startup timing to be later than in the typ state such that the startup timings are in time for an output timing t8. In this way, according to the embodiment, the startup timing is set to be responsive to the startup of each element, thereby controlling an increase in the power consumption of each element.

### Slow state

Referring to Fig. 3B, the sequential order of a startup timing t9 of the orthogonal modulation mixer 105, the local buffer amplifier 106, and the power amplifier 107, a startup timing t10 of the baseband buffer amplifier 103, and a startup timing t11 of the baseband phase shifter 102 is identical to the sequential order in the typ state (Fig. 2A), and has a relationship of t9 < t10 ≤ t11.

Referring to Fig. 3B, a timing t12 at which the radar transmitter 100 outputs the encoded pulse is identical the timing t4 in the "typ" state.

Referring to Fig. 3B, however, the timing determiner 108 sets the startup timings t9, t10, and t11 to be respectively earlier than the startup timings t1, t2, and t3 of the elements in the typ state. Namely, the relationship of t9 < t1, t10 < t2, and t11 < t3 holds true.

Alternatively, the timing determiner 108 may determine the timings t9, t10, and t11 from tstart using a program counter including a flipflop that works in response to a separately supplied clock signal. The timing determiner 108 may change the startup timings t9, t10, and t11 satisfying the above relationship in response to the process variations. For example, the timing determiner 108 may record, in advance, count values responsive to the process variations in a lookup table (LUT). The timing determiner 108 may calculate the count values in response to the output of the variation detector 109.

Since periods of time to start up the elements in the radar transmitter 100 are longer in the slow state than in the typ state, the timing determiner 108 sets the startup timing to be earlier such that the startup timings are in time for an output timing t12. In this way, according to the embodiment, the startup timing is set to be responsive to the startup of each element, thereby controlling an increase in the power consumption of each element.

The determination method of the startup timing in each of the elements in the radar transmitter 100 has been discussed.

In accordance with the embodiment, the radar apparatus 10 variably determines the startup timing of each element in response to the process variations of the semiconductors forming the radar transmitter 100. Each element of the radar transmitter 100 is started up at the startup timing that accounts for the startup time in view of the process variation. In accordance with the embodiment, a radar process of a pulse radar is performed in a power-consumption reduced state.

### Second Embodiment

### Configuration of apparatus

The configuration of a radio communication apparatus of a second embodiment is described below.

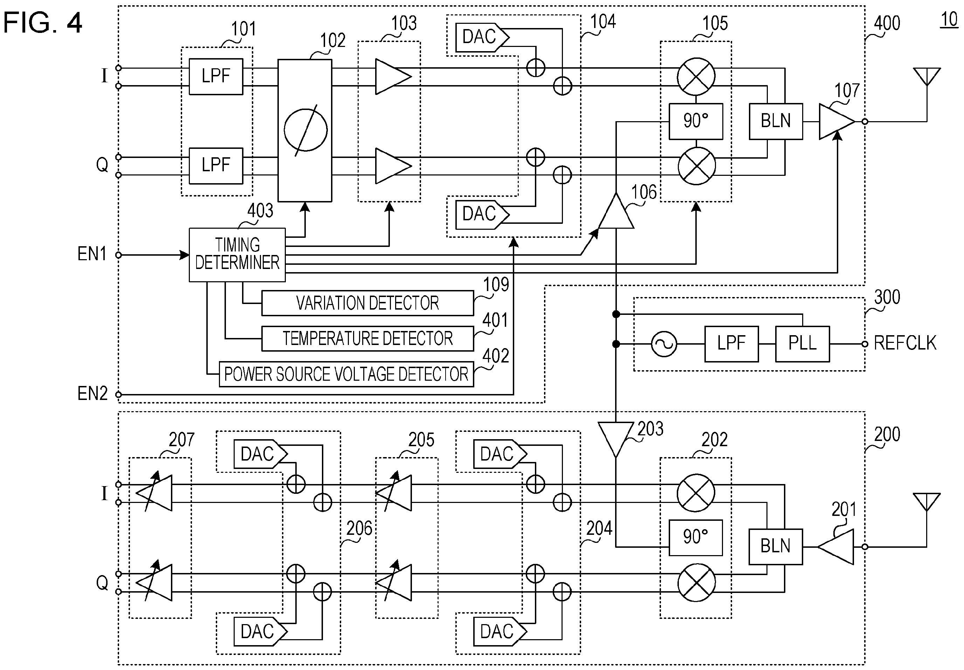

Fig. 4 illustrates an example of a radar apparatus 10 of the second embodiment. The radar apparatus 10 of Fig. 4 includes a radar transmitter 400, a radar receiver 200, and a local signal generator 300. Referring to Fig. 4, elements identical to those of Fig. 1 are designated with the same reference numerals and the discussion thereof is omitted herein.

The radar transmitter 400 includes a temperature detector 401 and a power source voltage detector 402 in addition to the configuration of the radar transmitter 100 of the first embodiment.

The temperature detector 401 detects the temperature of the radar transmitter 100. The power source voltage detector 402 detects the voltage value of the power source.

A timing determiner 403 determines the startup timing of each element in the radar transmitter 100 in accordance with the EN1 signal, information input from the variation detector 109, temperature information input from the temperature detector 401, and power source voltage information input from the power source voltage detector 402.

The timing determiner 403 determines the startup timing of the baseband phase shifter 102, the startup timing of the baseband buffer amplifier 103, and the startup timing of the orthogonal modulation mixer 105, the local buffer amplifier 106, and the power amplifier 107 such that the relationship described with reference to the first embodiment is satisfied.

In the same way as in the first embodiment, the timing determiner 403 sets the startup timing to be later in the fast state than in the typ state, and sets the startup timing to be earlier in the slow state than in the typ state.

If the temperature of the radar transmitter 400 is higher, the timing determiner 403 sets the startup timing to be later than in the typ state. If the temperature of the radar transmitter 400 is lower, the timing determiner 403 sets the startup timing to be earlier than in the typ state. This is because a period of time until the semiconductor starts up is shorter in a higher-temperature state, and because a period of time until the semiconductor starts up is longer in a lower-temperature state.

If the power source voltage of the radar transmitter 400 is higher, the timing determiner 403 sets the startup timing to be later than in the typ state. If the power source voltage of the radar transmitter 400 is lower, the timing determiner 403 sets the startup timing to be earlier than in the typ state. This is because a period of time until the operational condition of the semiconductor is satisfied becomes shorter as the power source voltage is higher, and the period of time until the operational condition of the semiconductor is satisfied becomes longer as the power source voltage is lower.

The timing determiner 403 may change startup timings in response to a combination of the process variations, temperature, and power source voltage. The timing determiner 403 may store in advance on a lookup table (LUT) a count value responsive to a combination of the process variations, temperature, and power source voltage. The timing determiner 108 may calculate the count value using outputs from the variation detector 109, the temperature detector 401, and the power source voltage detector 402.

A parameter used in the determination of the startup timing may be one of the process variation, temperature, and power source, or may be a parameter that affects another startup timing.

In accordance with the second embodiment, the radar transmitter 400 determines the startup timing of each element in response to the process variation as well as the temperature and the power source voltage of the radar transmitter 400. The radar transmitter 400 may thus set at a higher accuracy level the time to start up each element of the radar transmitter 100 and reduce the power consumption.

The embodiments have been discussed.

### Modifications of embodiments

In accordance with the embodiments, the orthogonal modulation mixer 105, the local buffer amplifier 106, and the power amplifier 107 are millimeter wave high-frequency circuits in each of the radar transmitters 100 and 400. The combination of millimeter wave high-frequency circuits is not limited to this combination.

Referring to Fig. 2A, the startup timing of the millimeter wave high-frequency circuit is t1. A startup command may be received by all the millimeter wave high frequency circuits prior to or at the startup timing t2 or t3 of the baseband circuit, and the startup timing may be different from element to element. The same is true of Fig. 2B, Fig. 3A, and Fig. 3B.

In accordance with the embodiments, the process variation of the radar transmitter 100 is detected in accordance with the threshold value of the MOS transistor. The disclosure is not limited to this method. For example, the variation detector 109 may detect variations of a resistor in a circuit forming the radar transmitter 100, or variations of a capacitor in a circuit forming the radar transmitter 100.

The first and second embodiments have been described with reference to the radar transmitter. The disclosure is not limited to the radar transmitter. The disclosure may be applied to a communication transmitter circuit. The startup method of the radar apparatus of the disclosure is applied not only to the radar apparatus but also another transmitter circuit.

### Conclusion

According an aspect of the disclosure, there is provided a radar apparatus. The radar apparatus includes a transmitter that intermittently transmits one or more radar signals with a plurality of circuits, with the circuits not being powered for a period of time throughout which the one or more radar signals are not transmitted, a variation detector that detects process variations of the circuits, and a determiner that determines a startup timing of each of the circuits in response to the process variations.

The radar apparatus may further include a temperature detector that detects a temperature of the transmitter. The determiner determines the startup timing in response to the process variations and the temperature.

The radar apparatus may further include a power source voltage detector that detects a power source voltage of the transmitter. The determiner determines the startup timing in response to the process variations and the power source voltage.

In the radar apparatus, the transmitter may include a baseband circuit and a high-frequency circuit. The determiner sets a startup timing of the high-frequency circuit to be earlier than a startup timing of the baseband circuit.

In the radar apparatus, the determiner sorts operational conditions of the circuits responsive to the process variations into a high-speed state, a standard state, and a low-speed state, sets the startup timing in the high-speed state to be later than the startup timing in the standard state, and sets the startup timing in the low-speed state to be earlier than the startup timing in the standard state.

In the radar apparatus, the transmitter includes an adjuster that adjusts a modulation error of the one or more radar signals. The adjuster is powered for the period of time throughout which the one or more radar signals are not transmitted.

The radar apparatus may further include a local oscillator that generates a local signal and a receiver that receives a signal reflected from an object in response to the one or more radar signals that are incident on the object. The local oscillator and the receiver are powered for the period of time throughout which the one or more radar signals are not transmitted.

In the radar apparatus, the variation detector detects, as the process variation, a variations in resistance of a resistor included in the circuits.

In the radar apparatus, the variation detector detects, as the process variation, a variations in a threshold value of a transistor included in the transmitter.

The radar apparatus may further include an orthogonal modulator that orthogonally modulates the one or more radar signals.

According to another aspect of the disclosure, there is provided a startup timing determination method. The startup determination method includes detecting process variations of a plurality of circuits included in a transmitter that intermittently transmits one or more radar signals, and suspending power supplying to the circuits for a period of time throughout which the one or more radar signals are not transmitted, and determining startup timings of the circuits in response to the process variations.

Process variations of multiple circuits included in a transmitter that intermittently transmits one or more radar signals using the circuits are detected. The circuits are not powered for the period of time throughout which the one or more radar signals are not transmitted. The startup timings of the circuits are determined in response to the process variations.

The disclosure is implemented using software, hardware, or software that operates in cooperation with the software.

Some or all of functional blocks described with reference to the embodiments are implemented as a large-scale integrated (LSI) circuit, and part or whole of each process described above may be controlled by a single LSI or a combination of LSIs. The LSI may include multiple chips or a single chip that includes some or all of the functional blocks. The LSI may include an input and an output for data. The LSI may be referred to as an IC, a system LSI, a super LSI, or an ultra LSI, depending on a difference in the degree of integration. The technique of circuit integration is not limited to the LSI. A dedicated circuit, a general-purpose processor, or a dedicated processor may be used.

A field programmable gate array (FPGA) or a configurable processor may be used. The FPGA is programmable after the manufacture of the LSI. The configurable processor is reconfigurable in terms of the connection and configuration of the internal LSI. The disclosure may be implemented in the form of digital processing or analog processing.

If a new integrated circuit technique that may replace the LSI technique appears as the semiconductor technology advances or as new technology is derived from the semiconductor technology, the functional blocks may be integrated using the new integrated circuit technique. For example, biotechnology is a possible option.

The embodiments of the disclosure find applications in the encoded pulse radar in terms of the reduction of the power consumption thereof.

## Claims

1. A radar apparatus comprising:
a transmitter including a plurality of circuits that intermittently transmit one or more radar signals, the plurality of circuits being suspended power supplying during a period in which the one or more radar signals are not transmitted;
variation detection circuitry that detects process variations of the plurality of circuits; and
determination circuitry that determines a startup timing of each of the plurality of circuits in response to the process variations and outputs startup commands in response to the determined startup timings to the plurality of circuits.

2. The radar apparatus according to Claim 1, comprising temperature detection circuitry that detects a temperature of the transmitter,
wherein the determination circuitry determines the startup timing in response to the process variations and the temperature.

3. The radar apparatus according to Claim 1, comprising power source voltage detection circuitry that detects a power source voltage of the transmitter,
wherein the determination circuitry determines the startup timing in response to the process variations and the power source voltage.

4. The radar apparatus according to Claim 1, wherein the plurality of circuits includes a baseband circuit and a high-frequency circuit,
wherein the determination circuitry sets a startup timing of the high-frequency circuit to be earlier than a startup timing of the baseband circuit.

5. The radar apparatus according to Claim 1, wherein the determination circuitry sorts operational conditions of the plurality of circuits responsive to the process variations into a higher-speed state, a standard state, and a lower-speed state, sets the startup timing in the higher-speed state to be later than the startup timing in the standard state, and sets the startup timing in the lower-speed state to be earlier than the startup timing in the standard state.

6. The radar apparatus according to Claim 1, wherein the transmitter comprises an adjuster that adjusts a modulation error of the one or more radar signals, and
wherein the adjuster is powered for the period which the one or more radar signals are not transmitted.

7. The radar apparatus according to Claim 1, comprising a local oscillator that generates a local signal and a receiver that receives a signal reflected from an object in response to the one or more radar signals that are reflected on the object,
wherein the local oscillator and the receiver are powered for the period which the one or more radar signals are not transmitted.

8. The radar apparatus according to Claim 1, wherein the process variation is a variation in resistance of a resistor included in the circuits.

9. The radar apparatus according to Claim 1, wherein the process variation is a variation in a threshold value of each of one or more transistors included in the transmitter.

10. The radar apparatus according to Claim 1, comprising an orthogonal modulator that orthogonally modulates the one or more radar signals.

11. A startup timing determination method, comprising:
detecting process variations of a plurality of circuits included in a transmitter that intermittently transmits one or more radar signals, the plurality of circuits being suspending power supplying during a period in which the one or more radar signals are not transmitted; and
determining a startup timing of each of the plurality of circuits in response to the process variations,
outputting startup commands in response to the determined startup timings to the plurality of circuits.
